Europäisches Patentamt

European Patent Office

Office européen des brevets

(11) Numéro de publication: **0 234 166 B1**

# FASCICULE DE BREVET EUROPEEN

(45) Date de publication de fascicule du brevet:
20.02.91

(51) Int. Cl.⁵: **G03F 1/00**

(21) Numéro de dépôt: 86420280.9

(22) Date de dépôt: **19.11.86**

(54) **Procédé de masquage et masque utilisé.**

(30) Priorité: 21.11.85 FR 8517487

(43) Date de publication de la demande:
02.09.87 Bulletin 87/36

(45) Mention de la délivrance du brevet:
20.02.91 Bulletin 91/08

(84) Etats contractants désignés:
**DE FR GB IT NL**

(56) Documents cités:

**IBM TECHNICAL DISCLOSURE BULLETIN, vol. 25, no. 4, septembre 1982, page 2057, New York, US; E. COURTENS: "Enhancement of edge exposure by modified photolithography masks for proximity printing on thick resists"**

**PATENTS ABSTRACTS OF JAPAN, vol. 9, no. 299 (P-408)[2022], 27 novembre 1985; & JP-A-60 135 949 (MATSUSHITA DENKO K.K.) 19-07-1985**

(73) Titulaire: **Dumant, Jean-Marc**
**8 Rue de la Torsade Crolles**
**F-38190 Brignoux(FR)**

Titulaire: **Latombe, Bruno**
**6, Rue Desnos**
**F-38400 Saint Martin D'Hères(FR)**

(72) Inventeur: **Dumant, Jean-Marc**
**8 Rue de la Torsade Crolles**
**F-38190 Brignoux(FR)**
Inventeur: **Latombe, Bruno**
**6, Rue Desnos**
**F-38400 Saint Martin D'Hères(FR)**

(74) Mandataire: **de Beaumont, Michel**
**1bis, rue Champollion**
**F-38000 Grenoble(FR)**

## Description

La présente invention concerne un procédé de masquage et un masque utilisé dans la mise en oeuvre de ce procédé. Elle concerne plus particulièrement les masques du type de ceux utilisés pour la fabrication des composants semiconducteurs discrets ou intégrés dans lesquels on souhaite former des motifs très fins, par exemple des motifs ayant des dimensions de l'ordre d'une fraction de micromètre à quelques micromètres.

La fabrication des circuits intégrés utilise la lithographie optique pour reproduire l'image d'un motif dessiné sur un masque. Cette image est formée sur une mince couche de produit photosensible elle-même déposée sur une couche d'un produit que l'on veut attaquer spécifiquement, par exemple une couche de silice. Une fois la résine insolée, les zones éclairées sont dissoutes par un produit de développement approprié, dans le cas d'un produit photosensible positif. Inversement, ce sont les couches non éclairées qui sont dissoutes dans le cas d'un produit photosensible négatif. Dans la présente demande, on considèrera seulement le cas d'une résine positive mais il sera clair que tout ce qui est dit ici peut s'appliquer inversement au cas d'une résine négative.

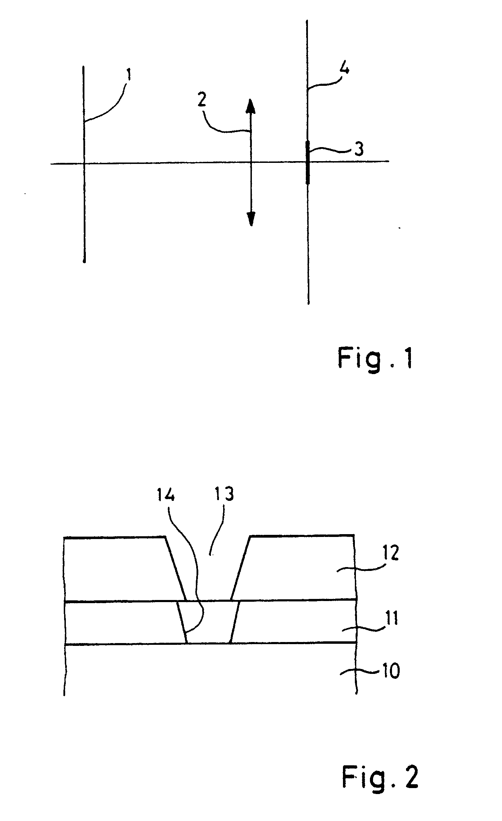

La figure 1 représente le schéma de base d'un procédé de masquage par projection. Etant donné un masque 1, son image est formée par un système optique 2 dans une zone 3 d'une tranche à traiter 4. Le masque peut correspondre au traitement d'ensemble de la tranche, ou bien le masque comprend un dessin de circuit intégré élémentaire qui est répété plusieurs fois sur la tranche par déplacement de celle-ci en des positions successives. Le masque ou réticule 1 est habituellement à une échelle comprise entre 1 et 10 par rapport à l'image que l'on veut obtenir sur la tranche.

Un exemple d'opération effectuée sur une tranche est illustré en figure 2. On considère un masque comprenant une couche opaque avec une ouverture en forme de fente, l'image de ce masque étant projetée sur une tranche comprenant par exemple un substrat de silicium 10 revêtu d'une couche 11 d'oxyde de silicium (SiO$_2$), elle-même revêtue d'une couche de produit photosensible 12 que l'on appellera ci-après résine. La résine est isolée à l'emplacement de l'image de la fente et, par suite d'une attaque par un produit sélectif, la zone insolée sera éliminée pour former dans la résine une ouverture 13. La pente des bords de cette ouverture est déterminée pour une bonne part par les caractéristiques du système d'exposition et en fait principalement par l'ouverture numérique du système de projection.

Une fois la couche de résine ouverte, on peut former une ouverture 14 dans la couche de silice sous-jacente par exemple par attaque au plasma. En ce cas, si l'on choisit un procédé d'attaque au plasma anisotrope, la pente des flancs de l'ouverture 14 ménagée dans la couche 11 dépendra de la pente des flancs de l'ouverture 13 dans la couche de résine 12. On peut montrer que, si l'on appelle B2 la pente des flancs de l'ouverture 14 et B1 la pente des flancs de l'ouverture 13, on a tgB2 = (V2/V1) tgB1, V2 et V1 étant les vitesses d'attaque respectives dans le plasma de la résine et de la silice (ou autre matériau constituant la couche 11). On voit donc qu'en contrôlant la pente des ouvertures formées dans la résine on pourra contrôler la pente des ouvertures formées dans la couche sous-jacente. Cette dernière pente présente un intérêt pratique important. En effet, dans l'exemple précédent, si l'ouverture 14 correspond à un contact de métallisation et que l'on veut établir une connexion par une métallisation, par exemple une métallisation d'aluminium, si les flancs de l'ouverture 14 sont trop raides, on aura des risques importants de cassure ou de non recouvrement de la couche d'aluminium aux coins supérieurs de l'ouverture 14 dans la couche de silice 11. Ce risque est fortement minoré si cette ouverture est légèrement évasée.

Il existe un autre intérêt pratique important. L'alignement automatique des machines d'exposition utilise le plus souvent le contraste créé par une marque gravée sur la plaquette à un précédent niveau de masquage. De tels systèmes sont en général sensibles aux épaisseurs des couches sous-jacentes. Si les bords de ces marques sont évasées, cette sensibilité est réduite en raison de l'augmentation de la diffraction.

Dans les cas où la technologie fait que les ouvertures que l'on veut former ont toujours des dimensions supérieures à quelques micromètres, plusieurs procédés existent pour adoucir les pentes des ouvertures formées dans la résine. Par exemple, un recuit après développement est possible, ce qui fait fluer la résine et arrondit les angles supérieurs des ouvertures. Par contre, quand on arrive à des technologies telles que les dimensions minimales de certains motifs sont de l'ordre du micromètre, l'épaisseur de la couche de résine est du même ordre que la largeur d'une bande que l'on souhaite maintenir en place. En ce cas, les techniques de fluage ne conviennent plus car des effets liés aux tensions superficielles se produisent et, par exemple, une bande d'un micromètre de largeur de résine au lieu de s'étaler sur la couche sous-jacente pourra tendre à se condenser pour atteindre une forme ovoïde.

En l'absence d'utilisation de techniques du type recuit de résine, la pente des ouvertures dans le motif est déterminée par les caractéristiques du système optique d'exposition et en fait principalement par l'ouverture numérique de ce système optique. Dans le cas où l'on cherche à former des motifs de dimension égale ou inférieure au micromètre, on est amené à choisir des systèmes à grande ouverture numérique, par exemple de l'ordre de 0,35 et il en résulte que les pentes des bords des ouvertures formées dans la résine sont naturellement de l'ordre de 80° ou plus.

Un objet de la présente invention est de prévoir un nouveau procédé pour obtenir une pente souhaitée dans une ouverture ménagée dans un produit photosensible.

Pour atteindre cet objet, la présente invention prévoit un procédé de masquage pour contrôler les zones limites d'irradiation d'une couche de produit photosensible par une source de rayonnement de longueur d'onde donnée, à travers un masque destiné à former sur la couche de produit photosensible une image donnée, par l'intermédiaire d'un système optique de limite de résolution déterminée, consistant à former à des frontières entre des zones opaques et transparentes du masque des bandes opaques d'une largeur choisie et espacées desdites frontières d'une distance choisie, ladite largeur et ladite distance étant telles que leurs valeurs multipliées par le facteur de réduction du système optique sont inférieures à la limite de résolution de celui-ci.

Ce procédé permet de contrôler la pente et plus particulièrement d'obtenir, pour un choix convenable du dimensionnement des bandes rajoutées au bord du motif de masque, des pentes de l'ordre de 65° qui conviennent généralement pour fournir ensuite des ouvertures de pente adaptée dans une couche sous-jacente.

Ces objets, caractéristiques et avantages de la présente invention seront exposés plus en détail dans la description suivante d'applications particulières de l'invention faite en relation avec les figures jointes parmi lesquelles :

la figure 1 représente de façon très schématique un système de photolithographie par projection classique ;

la figure 2 représente la formation d'ouvertures successives dans des couches superposées formées sur un substrat ;

les figures 3A à 8A représentent des allures de masques ; et

les figures 3B à 8B représentent les contours des motifs obtenus en conséquence dans une couche de résine photosensible après développement.

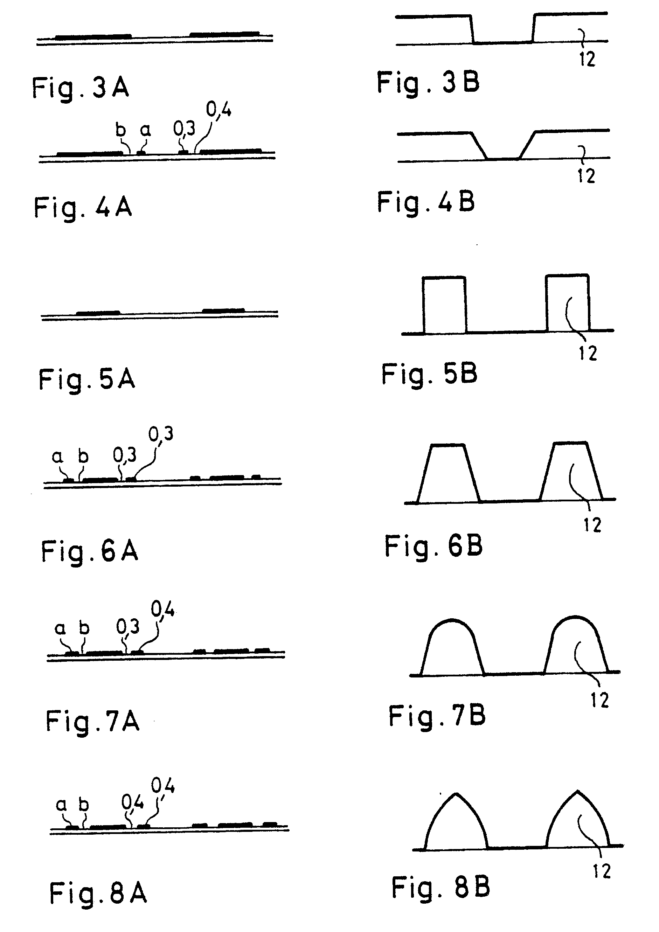

Ainsi, les figures 3B à 8B représentent l'allure de structures obtenues en utilisant des masques tels que ceux des figures 3A à 8A dans le cas où l'on utilise un système optique d'ouverture numérique égale à 0,35, l'épaisseur de la couche de produit photosensible étant légèrement supérieure à un micromètre, la longueur d'onde du rayonnement étant de 0,436 micromètre, et la limite de résolution du système optique étant sensiblement égale à 0,8 micromètre.

La figure 3A représente un masque échelle 1 opaque avec une ouverture en forme de fente d'une longueur de 1,5 micron. On obtient alors après développement dans une résine positive une ouverture dont les flancs ont une pente de 82°, comme le montre la figure 3B. La figure 5A représente le cas d'un masque comprenant deux bandes opaques larges de 1 micromètre et distances d'environ 2 micromètres. L'image résultante est indiquée en figure 5B : deux nervures de résine dont les flancs ont une pente de 82° environ.

Dans le cas où les frontières entre les zones opaques et les zones transparentes du masque sont bordées par des bandes opaques de largeur "a" espacées d'une distance "b" par rapport à ladite frontière, on obtient des résultats tels que ceux indiqués dans les figures 4B et 6B à 8B.

Pour la figure 4A, a = 0,3 et b = 0,4 micromètre de part et d'autre d'une ouverture dans un masque. On obtient alors une ouverture dont les flancs ont une pente de l'ordre de 65°. Une pente identique est obtenue dans le cas de nervures adjacentes si a = 0,4 et b = 0,3 micromètres (cas des figures 7A et 7B). Une plus faible pente est obtenue comme le représente la figure 6B dans le cas où sur le masque a = 0,3 et b = 0,3 (figure 6A). La figure 8B représente le cas où, sur le masque, a = b = 0,4 micromètres.

On voit donc qu'en choisissant les valeurs de a et b on peut faire varier dans une gamme importante les pentes des flancs des motifs fournis dans le résine, après développement.

Un autre paramètre à considérer est que les pentes varient avec la dose d'éclairement dans certains cas. On s'aperçoit expérimentalement que, pour certains choix des couples a et b, cette sensibilité à la dose d'éclairement diminue beaucoup, c'est-à-dire que l'on obtient sensiblement les mêmes pentes pour une configuration donnée quel que soit l'éclairement. C'est par exemple le cas de la structure des figures 4A-4B.

Dans ce qui précède, quand on a donné des dimensions pour des valeurs a et b, on a considéré, pour simplifier l'exposé, que le masque était à la même échelle que le motif que l'on souhaitait obtenir. Bien entendu, dans le cas d'un masque à échelle agrandie, et d'un système optique réducteur, les valeurs de a et b devront être multipliées par le grandissement du système optique. Par exemple, pour un masque à échelle 10, les valeurs indiquées ci-dessus pour a et b devront être multipliées par 10. On voit qu'alors elles sont simplement réalisables sur le masque avec des moyens classiques. Néanmoins, même dans le cas d'un masque à échelle 1, on pourra en choisissant des méthodes particulières, par exemple une réalisation du masque par des faisceaux électroniques, obtenir sur les masques des dessins très fins permettant de réaliser les bandes selon la présente invention.

Des études menées par les inventeurs ont montré qu'il était possible d'obtenir, dans des conditions normales de gravure et d'éclairement, une pente donnée B pour les flancs d'une ouverture dans une couche de résine en choisissant les valeurs a et b définies ci-dessus sensiblement d'après la formule suivante :

$$B = \text{Arc tg } (a/b) \, [e.R/(a+b)] \quad (1)$$

où :

e est l'épaisseur de la couche de résine,
R est le facteur de réduction du système optique de projetion.

Par exemple, dans le cas où a et b sont compris entre 2 et $5 \times 10^{-6}$ m, e = $1,2 \; 10^{-6}$ m, R = 10, on a relevé les valeurs suivantes:

| b (10-6m) | a (10-6m) | B calculé (degrés) | B mesuré (degrés) |
|---|---|---|---|
| | 0 | 90 | 82 |
| 2 | 4 | 76 | 75 |
| 3 | 3 | 63 | 67 |
| 3 | 4 | 66 | 65 |
| 4 | 4 | 56 | 55 |

Dans ce tableau la première ligne correspond au cas où l'invention n'est pas utilisée. On voit alors un net écart entre la formule (1) théorique et le résultat observé ce qui est bien normal dans ce cas limite.

Le passage d'un masque classique à un masque dont les frontières sont munies de bandes opaques selon la présente invention, s'effectue dans les fichiers informatiques après que les concepteurs ont terminé leur dessin de circuit. Il s'agit d'un traitement simple analogue à celui mis en oeuvre de façon classique pour les opérations d'épurage et de codage de masque.

La présente invention est susceptible de diverses variantes qui apparaîtront à l'homme de l'art. Par exemple, au lieu d'une bande latérale de chaque côté d'un motif, on pourra prévoir plusieurs bandes latérals.

## Revendications

1. Procédé de gravure d'un motif d'ouvertures dans une couche de produit photosensible par photolithogravure, c'est-à-dire en projetant l'image d'un masque portant ledit motif par un système optique sur ladite couche et en éliminant sélectivement par attaque chimique les zones insolées ou non insolées, dans lequel on veut conférer aux flancs des ouvertures une pente déterminée B, caractérisé en ce qu'il consiste à former aux frontières entre les zones opaques et transparentes du masque des bandes opaques de largeur a espacées desdites frontières d'une distance b , et à sélectionner a et b pour que :

   - les produits axR et bxR soient inférieurs à la limite de résolution du système optique, R étant le facteur de réduction du système optique,
   - on obtient la pente B recherchée celle-ci étant liée à a et b par la formule suivante :
   $$B = \text{Arctg } (a/b) \, [e.R/(a+b)]$$
   où : e est l'épaisseur de la couche de produit photosensible.

## Claims

1.  A method for etching an aperture pattern in a photoresist material layer by photolithography, that is, by projecting the image of a mask incorporating said pattern by means of an optical system on said layer and by selectively chemically etching the irradiated or non-irradiated areas wherein it is desired that the edges of the apertures have a determined slope, characterized by forming at the limits between dark and transparent areas of the mask dark stripes having a width a and spaced apart said limits by a distance b, and selecting a and b so that:
    - the products axR and bxR are lower than the resolution limit of the optical system, R being the reduction factor of the optical system,
    - the desired slope B is obtained, the latter being associated to a and b by the following formula:
    $$B = \text{Arc tan } (a/b) \, [e.R/(a+b)]$$
    where: e is the thickness of the photoresist material layer.

## Ansprüche

1.  Verfahren zum Ätzen eines Lochmusters in eine Schicht aus lichtempfindlichem Material durch Photolithographie, d.h. durch Projizieren des Bildes einer das Muster tragenden Maske über ein optisches System auf die Schicht und durch ausgewähltes chemisches Abtragen der bestrahlten oder nichtbestrahlten Bereiche, in dem auf die Flanken der Öffnungen eine bestimmte Steigung B übertragen werden soll,

    **dadurch gekennzeichnet,**

    daß in den Grenzen zwischen den undurchsichtigen und durchsichtigen Bereichen der Maske undurchsichtige Streifen der Breite a im Abstand b von den Grenzen entfernt angeordnet und a und b so ausgewählt werden, daß:
    - die Produkte a x R und b x R kleiner sind als die Auflösungsgrenze des optischen Systems, wobei R der Reduktionsfaktor des optischen Systems ist,
    - man die gewünschte Steigung B erhält, die mit a und b durch die folgende Formel verknüpft ist:
    $$B = \text{Arctg } (a/b)[e.R/(a+b)],$$
    in der e die Dicke der Schicht aus photoempfindlichem Material ist.

Fig. 1

Fig. 2

Fig. 3 A

Fig. 3 B

Fig. 4 A

Fig. 4 B

Fig. 5 A

Fig. 5 B

Fig. 6 A

Fig. 6 B

Fig. 7 A

Fig. 7 B

Fig. 8 A

Fig. 8 B